# EUROPEAN PATENT SPECIFICATION

(11) **EP 3 542 433 B1**
(45) Date of publication and mention of the grant of the patent: **28.06.2023**
(21) Application number: 16801403.3
(22) Date of filing: 15.11.2016
(51) Int. Cl.: H02J 3/01, G01R 19/25

(54) **MONITORING ARRANGEMENT FOR DOMESTIC OR COMMERCIAL ELECTRICAL APPLIANCES**
ÜBERWACHUNGSANORDNUNG FÜR HAUSHALTS- ODER GEWERBLICHE ELEKTROGERÄTE
AGENCEMENT DE SURVEILLANCE DESTINÉ À DES APPAREILS ÉLECTRIQUES DOMESTIQUES OU COMMERCIAUX

(43) Date of publication of application: 25.09.2019
(73) Proprietor: Electrolux Appliances Aktiebolag, 105 45 Stockholm (SE)
(72) Inventor: RIZZO, Luca, 33080 Porcia Pordenone (IT)
(74) Representative: Electrolux Group Patents
(86) International application number: PCT/EP2016/077673
(87) International publication number: WO 2018/091067

(56) References cited:
- EP-A2- 1 868 278
- US-A1- 2012 041 696
- US-A1- 2014 168 843
- US-A1- 2016 080 840
- US-B2- 7 282 921
- AKBAR M ET AL: "Modified Nonintrusive Appliance Load Monitoring For Nonlinear Devices", MULTITOPIC CONFERENCE, 2007. INMIC 2007. IEEE INTERNATIONAL, IEEE, PISCATAWAY, NJ, USA, 28 December 2007 (2007-12-28), pages 1-5, XP031282541, ISBN: 978-1-4244-1552-6
- HART G W: "NONINTRUSIVE APPLIANCE LOAD MONITORING", PROCEEDINGS OF THE IEEE, IEEE. NEW YORK, US, vol. 80, no. 12, 1 December 1992 (1992-12-01), pages 1870-1891, XP000336363, ISSN: 0018-9219, DOI: 10.1109/5.192069

## Description

### Background of the Invention

### Field of the Invention

The present invention refers in general to the field of domestic or commercial (called also professional) electric appliances, and more particularly to a monitoring arrangement for domestic or commercial electric appliances like a domestic o commercial refrigerator, a domestic or commercial laundry washing machine, a domestic or commercial laundry dryer machine, a domestic or commercial combined laundry washing and drying machine, a domestic or commercial dishwasher, a domestic or commercial oven, an air conditioner, and the like, and in general for all those domestic or commercial electric appliances comprising at least one electric load adapted for being supplied with AC current.

### Overview of the Related Art

With the development of intelligent appliance technology, the proliferation of electric appliances provided with monitoring capabilities adapted to collect real-time information about their operating condition as well as about the surrounding environment is increasing. Such information may relate to a very large number of different aspects, such as the instantaneous power consumption of the appliance, the assessment of overload and/or malfunctioning conditions, the operating status of the various electric loads of the appliance, the condition of the AC power grid, and so on. Electric appliances provided with this capability may advantageously avail of this kind of information to improve their operating efficiency, such as for example by promptly signaling the occurrence of possible malfunctioning to the user or by optimizing the management of the electric power consumption. Moreover, environmental and economic reasons have brought to the diffusion of renewable electric power generation units (e.g. solar panels or wind turbines), whose electric power generation capabilities fluctuate based for example on the weather conditions. Therefore, in order to further improve their operating efficiency, intelligent electric appliances should be also aware of the real-time availability of electric power generated by said renewable electric power generation.

It is known that a reliable way for an electric appliance to obtain the information mentioned above is the monitoring of the AC current absorbed by the electric appliance itself (i.e. the overall current consumption of the electric appliance) by means of a current sensor.

For example, patent US 4741170 discloses an improved control for a refrigerator. Critical components such as fresh food and freezer compartment temperature sensors, temperature set devices and baffle are sampled to confirm that each is operational. Upon diagnosis of a critical component failure or of multiple component failures, the control, using stored control parameters, operates the remaining components in a manner that will continue to preserve food.

Patent US 46151779 discloses an apparatus and method for detecting a failure in an automatic defrost system for a refrigerator. A current sensor means monitors the current supplied to the defrost heater and generates an "on" signal when current is sensed in the defrost heater circuit. A microprocessor determines the "off" time, that is the time between successive "on" signals, and compares this time to a predetermined reference time longer than the normal "off" time. A user discernible signal is generated upon detection of an "off" time greater than the reference time, signifying to the user that the defrost system is not operating properly, and corrective action may be necessary.

Patent JPH04359778 discloses a current transformer for detecting a current flowing a power source line. A controller compares the detected current value of the transformer with both upper and lower reference values, judges as a malfunction if the current value is out of both the upper and lower reference values, displays it on a display unit, and opens a relay switch of the component which is conducted at that time. In this case, the controller varies the upper reference values and the lower reference values in response to the component to be conducted of a dew-preventive heater, a defrosting heater, a driving motor of a fan and a compressor.

US 2016/080840 discloses to capture at a relatively high data rate power consumption related data for the power source supplying an entire household or other group of appliances. The raw data is analysed to remove redundancy and to identify pertinent features, and then the more informative of these features are selected. The analysis and selection of features are pre-processing tasks that are performed on-site, on the same piece of hardware that acquires the raw data and transmits the pre-processed data to the server. By transmitting selective data to a remote server, only a low bandwidth is required for the transmission.

### Summary of the Invention

Applicant has found that the known solutions mentioned above are not satisfactory, since they allow collecting only a subset of the information that can be exploited for improving the operation of an electric appliance.

Therefore, in view of the above, Applicant has faced the problem of how to improve the monitoring capabilities of electric appliances.

An aspect of the present invention related to a domestic or commercial (typically called also professional) electric appliance.

The domestic or commercial electric appliance comprises at least one electric load, an AC power supply input connectable to an AC power source for receiving electric power from said power source and arranged to supply electric power to said at least one electric load.

The AC power source comprises a private available AC power supply connected to said power supply unit, wherein the private available AC power supply is an AC power generator which is directly managed by a private user, comprises a modulator unit adapted to modulate AC current generated by the private AC power supply with an identification signal when the AC power generator is operating and delivering additional power and further comprises a domestic photovoltaic panel or a micro-wind turbine generator.

The domestic or commercial electric appliance further comprises a current sensor for sensing an AC current absorbed by the electric appliance from the AC power source (i.e. the overall current consumption of the electric appliance), and a processing unit for carrying out an harmonic analysis on a sensed AC current sensed by the current sensor and for driving the at least one electric load based on an outcome of said harmonic analysis.

The processing unit is configured to assess a presence, in a sensed AC current, of at least one secondary component oscillating at a frequency higher than a fundamental frequency of a main component of said sensed AC current, and to detect if said at least one secondary component corresponds to an identification signal generated by the private available AC power supply, wherein the processing unit is further configured to drive said at least one electric load based on said identification signal.

According to an embodiment of the present invention, said current sensor is a Hall current sensor.

According to an advantageous embodiment of the present invention, the processing unit is configured to calculate the total harmonic distortion of the sensed AC current, and to assess at least one among:
- malfunctioning conditions of the at least one electric load, and
- disturbances on the AC power source caused by other electric appliances,
based on the calculated total harmonic distortion.

According to an advantageous embodiment of the present invention, the processing unit is configured to carry out the harmonic analysis on the sensed AC current by applying a Fast Fourier Transform to the sensed AC current.

According to an advantageous embodiment of the present invention, the processing unit is configured to assess anomalous operation conditions or malfunction conditions of the at least one electric load based on the sensed AC current.

According to an advantageous embodiment of the present invention, the processing unit is further configured to assess the electric power consumption of the at least one electric load based on the sensed AC current.

According to an advantageous embodiment of the present invention, the processing unit is further configured to assess an overload condition of the AC power source based on sensed AC current.

According to an advantageous embodiment of the present invention, said electric appliance is a refrigerator, and said at least one electric load comprise at least one among an inverter unit, a compressor unit, and a defrost heating resistor.

According to an advantageous embodiment of the present invention, said electric appliance is a laundry washing machine, and said at least one electric load comprises at least one among a drain pump, a recirculation pump, a drum motor circuit, a heating resistor.

According to an advantageous embodiment of the present invention, said electric appliance is a laundry dryer machine, and said at least one electric load comprises at least one among a drum motor circuit, a heating resistor, a compressor unit, a fan.

According to an advantageous embodiment of the present invention, said electric appliance is an oven, and said at least one electric load comprises at least one among a heating resistor, a microwave generator unit, a fan.

Another aspect of the present invention relates to an electric system comprising a domestic or commercial (typically called also professional) electric appliance and an AC power source connected to the AC power supply input of said domestic or commercial electric appliance. Said AC power source is adapted to provide to said AC power supply input an electric power having a fundamental frequency being an utility frequency of a public available AC power supply.

According to an advantageous embodiment of the present invention, said AC power source includes at least one private available AC power supply, wherein the private available AC power supply is an AC power generator which is directly managed by a private user. Each private available AC power supply is configured to generate additional electric power and a corresponding identification signal when activated.

### Brief Description of the Drawings

These and others features and advantages of the solution according to the present invention will be better understood by reading the following detailed description of an embodiment thereof, provided merely by way of non-limitative example, to be read in conjunction with the attached drawings, wherein:
**Figure 1** is an exemplificative scenario comprising an electric appliance in which concepts according to embodiments of the present invention can be applied;
**Figure 2** is a very simplified schematic showing the main blocks of a current sensor comprised in the electric appliance of **Figure 1** according to an exemplary embodiment of the present invention, and
**Figure 3** is an equivalent circuit of the current sensor of **Figure 2** and of an electric load of the appliance of **Figure 1****.**

### Detailed Description

Embodiments of the present invention relate to a domestic or commercial (called also professional) electric appliance designed to be supplied with AC current and provided with the capability of monitoring the AC current absorbed by the electric appliance itself (i.e. the overall current consumption of the electric appliance) for obtaining real-time information about its operating condition as well as about the surrounding environment.

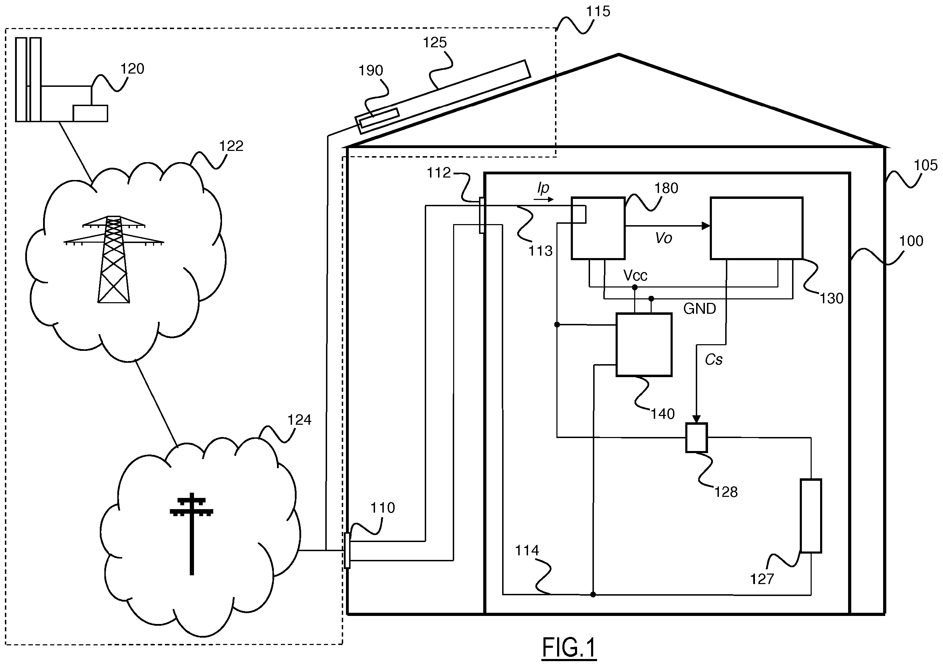

In order to describe advantageous embodiments of the present invention, reference will be now made to the exemplary scenario illustrated in **Figure 1****,** wherein an electric appliance **100,** *e.g.,* an electric household appliance - such as a refrigerator, a laundry washing machine, a laundry dryer machine, a combined laundry washing and drying machine, a dishwasher, an oven, an air conditioner and the like - located in a building **105,** is connected to a power socket **110** for being supplied with AC power. Although in **Figure 1** the electric appliance **100** is an household appliance for the domestic use, similar considerations apply in case the electric appliance **100** is a commercial (or professional) electric appliance, *i.e.,* an electrical appliance adapted to be employed in commercial (or professional) settings such as in restaurants, refectories, warehouses, laundromats, and the like.

The electric appliance **100** comprises an AC power supply input **112** electrically coupled to the power socket **110,** *e.g.* by means of an AC power cord, for receiving electric power from an AC power source **115.** The AC power supply input **112** preferably comprises a first terminal (line) **113** and a second terminal (neutral) **114.** The voltage difference between line **113** and neutral **114** oscillates, for example at a frequency of 50 or 60 Hz, causing AC current to flow across a generic electric load when connected between line **113** and neutral **114.**

In the present document, the term "AC power source" **115** is an umbrella term comprising known means/structures/units/apparatuses for generating and/or transforming, and/or delivering, and/or converting AC electric power; in the example shown in **Figure 1** electric power supplied by the AC power source **115** is available at the power socket **110.**

Making reference to the exemplary scenario illustrated in **Figure 1****,** the AC power source **115** is preferably an interconnected network (electric grid) for delivering electricity from suppliers to consumers, which comprises, for example, public available AC power supplies **120,** that produce electrical power, preferably high-voltage transmission grids **122** comprising high-voltage transmission lines for carrying power from the (typically distant) public available AC power supplies **120** to demand centers, and, preferably, medium-voltage distribution grids **124** for connecting individual customers, such as the building **105** wherein the power socket **110** is located. The oscillation frequency of voltage difference between line **113** and neutral **114** generated by the AC power source **115,** *e.g.,* by at least one public available AC power supply **120,** is also referred to as utility frequency.

In the present document, by "public available AC power supply" it is intended any kind of AC power station which is managed by an electric utility and is adapted to generate AC power to be delivered to a plurality of users, for example having made a subscription to such electric utility. Examples of public available AC power supplies may comprise fossil-fuel power stations, nuclear stations, hydro-electric stations, photovoltaic power stations, and the like.

The AC power source **115** may advantageously further comprise at least one private available AC power supply **125** - also referred to as additional AC power supply- , such as a renewable power supply, for example a photovoltaic panel or a wind turbine, preferably, but not necessarily, directly located at the building **105** or close to the latter.

In the present document, by *"private available AC power supply"* it is intended any kind of AC power generator which is directly managed by a private user. Examples of private available AC power supplies **125** may comprise domestic photovoltaic panels and micro-wind turbine generators.

Such private available AC power supply **125** is configured to provide additional electric power to be available at the power socket **110** when such private available AC power supply **125** is in the condition to operate, *e.g.,* in presence of sun rays or in presence of wind, and when is actually activated.

The electric appliance **100** comprises one or more electric loads **127** (only one visible in Figure 1).

In case the electric appliance **100** is a refrigerator, possible non limitative examples of electric loads **127** may comprise a compressor unit for the circulating refrigerant, an inverter for driving the compressor unit, and a heating resistor for performing defrost cycles.

If the electric appliance **100** is a laundry washing machine, possible non limitative examples of electric loads **127** may comprise a motor for rotating a washer drum, an inverter for driving such motor, a drain pump for draining washing liquid from a washing tub, a recirculation pump for recirculating washing liquid, and a heating resistor for heating washing liquid.

If the electric appliance **100** is a laundry dyer machine, possible non limitative examples of electric loads **127** may comprise a motor for rotating a dryer drum, an inverter for driving such motor, a fan for propelling drying air, a heating resistor for heating drying air, and a compressor for the heat pump circuit.

If the electric appliance **100** is an oven, possible non limitative examples of electric loads may comprise a heating resistor for heating a cooking chamber, a microwave generator for generating microwaves radiation to be provided in the cooking chamber, and a fan for circulating air inside the cooking chamber.

The generic electric load **127** is preferably driven by a respective driving apparatus **128** which may advantageously comprise a relay, a TRIAC, or other controllable switching means preferably arranged to selectively couple said electric load **127** between line **113** and neutral **114,** to enable AC current flowing across the electric load **127.**

For example, according to an advantageous embodiment of the present invention, the driving apparatus **128** has preferably a first conduction terminal electrically coupled to the line **113,** preferably a second conduction terminal coupled to a first terminal of the respective electric load **127,** and, preferably, a control terminal adapted to receive a control signal CS from a processing unit (control unit) **130** of the appliance **100** (*e*.*g*., consisting of or comprising a microprocessor) directed to manage the operation of the appliance **100.** Without descending into technical details well known to those skilled in the art, the driving apparatus **128** is preferably designed to be switched between a non-conductive condition, in which its first conduction terminal is electrically decoupled from its second conduction terminal, and a conductive condition, in which its first conduction terminal is electrically coupled with its second conduction terminal based on the control signal CS received by the driving apparatus **128.**

When the driving apparatus **128** is in the non-conductive condition, the respective electric load **127** is electrically decoupled from the line **113,** and therefore no current flows across it.

When the driving apparatus **128** is in the conductive condition, the respective electric load **127** is electrically coupled between line **113** and neutral **114,** so that AC current flows across the electric load **127** itself. As it is well known to those skilled in the art, if the driving apparatus **128** is for example a TRIAC, the electric power transferred to the electric load **127** can be adjusted by setting the control signal *CS* in such a way to switch the TRIAC in the conductive state at an adjustable time (phase angle) after the start of each half-cycle of the AC voltage difference between line **113** and neutral **114,** thereby altering the actual voltage difference waveform applied between the electric load **127** terminals and so changing its RMS (Root Mean Square) effective value.

Clearly, other possible kind and arrangements of driving apparatus **128** can be used, provided that they are able to selectively allow/prevent the AC current to flow across the electric load **127.**

Also the processing unit (control unit) **130** of the appliance **100** can be different and/or differently arranged/connected with respect to the one shown in **Figure 1**.

The electric appliance **100** preferably comprises an AC-DC conversion circuit (only conceptually illustrated in the figure and denoted, as a whole, by the reference **140**), comprising, for example, transforming, rectifying and regulation components for receiving an AC voltage (*e.g*., from line **113** and neutral **114**) and providing, for example, one or more DC voltages, such as a ground voltage **GND** and a DC supply voltage **Vcc** *(e.g.,* a 3V, 5V or 12V DC voltage with respect to the ground voltage **GND**). The DC voltage(s) generated by the AC-DC conversion unit **140** can be for example used for supplying - among others - the control unit **130** directed to manage the operation of the appliance **100.**

The electric appliance **100** further comprises a current sensor **180** configured to measure, preferably in real-time, the (total) AC current *Ip* absorbed by the electric appliance **100** through the power socket **110** (i.e. the overall current consumption of the electric appliance); advantageously the current sensor **180** is configured to provide the outcome of such measure to the control unit **130.** As will be described in detail in the following of the present description, the control unit **130** is preferably configured to set the control signal CS - for controlling the driving apparatus **128** - based on the measure carried out by the current sensor **180.**

The current sensor **180** is preferably connected in series to the line **113** at the AC power supply input **112,** preferably in order to be upstream the other elements included in the electric appliance **100.** Preferably, but not necessarily, the current sensor **180** may be supplied with the DC voltages **GND** and **Vcc** generated by the AC-DC conversion unit **140.**

According to an advantageous embodiment of the present invention, the current sensor **180** is a current sensor exploiting the Hall effect to measure the AC current absorbed by the electric appliance **100** (i.e. the overall current consumption of the electric appliance).

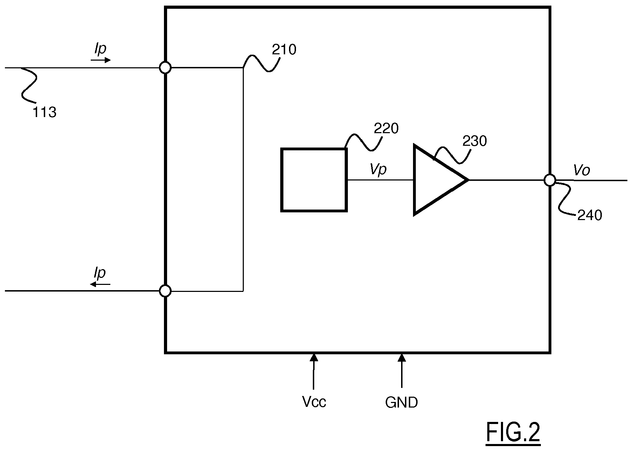

**Figure 2** is a very simplified schematic showing the main blocks of the current sensor **180** according to an exemplary embodiment of the present invention. The current sensor **180** preferably comprises a primary conduction path **210** adapted to be crossed by the AC current *Ip* absorbed by the electric appliance **100.** The current sensor preferably further comprises an (*e*.*g*., integrated) Hall sensor module **220** adapted to sense the magnetic field generated by the passage of the AC current *Ip* across the primary conduction path **210** and to generate a corresponding electric signal, for example a corresponding voltage *Vp,* proportional to the sensed magnetic field. The corresponding electric signal, *e.g.* voltage *Vp,* is preferably fed to a conditioning section **230** of the current sensor **180** (preferably comprising filters, amplifiers and offset circuits) for the generation of a corresponding output electric signal, *e.g.* a corresponding output voltage *Vo,* that is preferably made available at an output terminal **240** of the current sensor **180.** The output electric signal, *e*.*g.* output voltage *Vo* generated by the conditioning section **230** is an AC electric signal, *e.g.,* an AC voltage proportional to the AC current *Ip,* and advantageously follows in real time the oscillations of the latter with the same frequency and phase. In order to maximize the output dynamic, the conditioning section **230** is preferably arranged such as to introduce in the output voltage *Vo* an offset, preferably equal to half the value of the supply voltage **Vcc.**

The output terminal **240** of the current sensor **180** is preferably connected to an analog input terminal of the control unit **130** (see **Figure 1****)** to provide the output voltage *Vo* to the latter. The control unit **130** is preferably configured to set the control signal *CS* for controlling the driving apparatus **128** based on the received output voltage *Vo*, as will be described in following portions of the present description. Without descending into particulars well known to those skilled in the art, the control unit **130** may preferably comprise a sampling unit coupled to the analog input terminal for sampling the output voltage *Vo* received from the current sensor **180**; the control unit **130** may preferably comprise an analog-to-digital conversion unit adapted to convert the analog sampled values generated by the sampling unit into digital values which can be processed by other (*e.g.,* firmware, or software) processing modules of the control unit **130.** Moreover, similar considerations apply if the output voltage *Vo* is provided to the control unit **130** in a different way, for example, with a sampling unit and an analog-to-digital conversion unit located outside the control unit **130** itself.

Compared with other known current sensors typically installed in electric appliances - such as the so-called shunt current sensors in which a sensing voltage is generated by amplifying the voltage drop on a resistor ("shunt resistor") in series to the path wherein the current to be sensed is flowing - the current sensor **180** has a very low input electrical resistance, for example 0.6 mΩ, given by the resistance of the primary conduction path **210.** Thanks to the low input electrical resistance value, the current sensor **180** has a very low power consumption. Moreover, compared to other current sensors, such as the shunt current sensor, the current sensor **180** has the primary conduction path **210** that is advantageously galvanically insulated from the other parts of the current sensor **180.**

Thanks to the current sensor **180,** the control unit **130** is able to monitor, preferably in real-time, the AC current *Ip* absorbed by the electric appliance **100** (i.e. the overall current consumption of the electric appliance). In this way, the control unit **130** obtains, preferably real-time, information about the electric appliance **100** operating condition, and preferably also about the surrounding environment, and can control the electric appliance **100** according to such information.

For example, the control unit **130** may detect anomalous conditions of the electric load **127** based on the monitored current *Ip.* If the current *Ip* is too high, it may mean that a short-circuit is occurred, or, in case the electric load **127** is a compressor or a motor, it may mean that the rotor of the compressor or of the motor is blocked. If the current *Ip* is too low, it may mean the presence of open circuits. In any case, the control unit **130** may use the acknowledged information to inform the user *(e.g.,* through audio and/or visual warning signals) or to take measures *(e.g.,* turning off the electric loads **127**).

The control unit **130** may preferably assess malfunctioning conditions of each individual electric load **127** of the electric appliance **100** by considering the monitored current *Ip* absorbed by the electric appliance **100** (i.e. the overall current consumption of the electric appliance) at the activation of such individual electric load **127.**

By knowing the electrical resistance of the electric loads **127,** the control unit **130** may use the value of the monitored current *Ip* absorbed by the electric appliance **100** (i.e. the overall current consumption of the electric appliance) for having a, preferably real-time, measurement of the power consumed by the electric appliance **100,** or obtaining measures of the voltage provided by the AC power source **115** at different times, for example for assessing possible anomalous conditions of the AC power source **115.**

Preferably, the control unit **130** may also detect overloads in the AC power source **115** by checking if the utility frequency of the AC power source **115** (and, therefore, of the current *Ip*) is subjected to drifts.

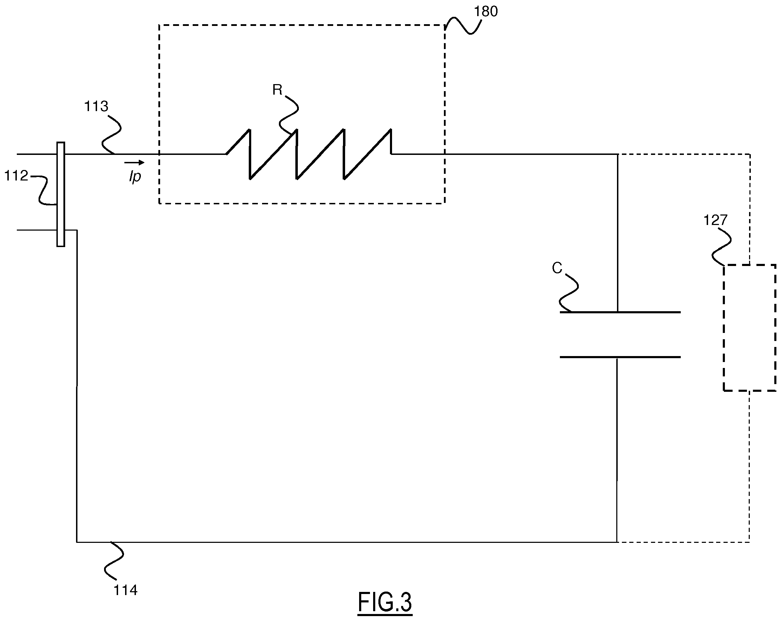

As can be seen in the equivalent circuit of **Figure 3****,** the input resistance of the current sensor **180,** identified in **Figure 3** with reference **R,** forms a low-pass filter together with the equivalent capacitance of the electric loads **127,** identified in **Figure 3** with reference C. As it is well known to those skilled in the art, the frequency of the main pole of a low-pass filter of this kind is inversely proportional to the value of the resistance **R.** Therefore, the lower the input resistance **R,** the wider the range of frequencies which is not filtered out by the low-pass filter.

Since the current sensor **180** according to the preferred embodiments of the present invention has a low input resistance, the control unit **130** may monitor the current *Ip* absorbed by the electric appliance **100** (i.e. the overall current consumption of the electric appliance) over a wide range of frequencies.

Making for example reference to an electric load equivalent capacitance **C** of 300 µF (which is a plausible value for the case in which the electric load **127** is a compressor of a refrigerator), using the current sensor **180** with an input resistance of 0.6 mΩ forms a low-pass filter having a main pole located at a frequency of about 884 kHz. Therefore, in this exemplary case, the control unit **130** is able to detect components of the current *Ip* oscillating at frequencies up to 884 kHz.

If a current sensor comprising a shunt resistor was used in place of the current sensor **180,** the main pole would be at a very lower frequency. For example, a typical input resistance of a current sensor comprising a shunt resistor may be 1Ω, and therefore, with a same electric load equivalent capacitance of 300 µF, the main pole would be at a frequency of about 531 Hz. In this case, the control unit **130** would be able to detect components on the current *Ip* occurring at frequencies up to 531 Hz only (less than three order of magnitude lower than with the current sensor **180** exploiting the Hall effect).

In view of the above, since the current sensor **180** according to an advantageous embodiments of the present invention has a low input resistance, the control unit **130** is allowed to receive from the current sensor **180** a signal having a harmonic content very similar to the one of the current *Ip,* because the number of frequency components that are filtered out is strongly reduced. Thanks to this feature, according to an advantageous embodiment of the present invention the control unit **130** is allowed to carry out an harmonic analysis on a signal which is very similar (from the frequency point of view) to the current *Ip,* comprising a large portion of the whole frequency content of the current *Ip* (*i.e.* up to frequencies corresponding to its main pole). If a different current sensor was employed (which is however possible according to the invention) having a higher input resistance, the control unit **130** would receive a signal comprising a lower portion of the whole frequency content of the current *Ip* (comprising less frequency components), and therefore a harmonic analysis would be less reliable.

According to an advantageous embodiment of the present invention, the control unit **130** is configured to carry out said harmonic analysis by using frequency domain operations such as the Fast Fourier Transform (FFT), for example implemented by firmware and/or software modules of the control unit **130.**

For example, according to an advantageous embodiment of the present invention, the control unit **130** may assess the presence of secondary components of the monitored current *Ip* oscillating at frequencies higher than the fundamental frequency (*i*.*e*., the utility frequency) of the main component of the monitored current *Ip.*

As another example, according to an advantageous embodiment of the present invention, the control unit **130** may calculate the total harmonic distortion *THD* of the AC current *Ip* absorbed by the electric appliance **100** to obtain an accurate measurement of the harmonic distortion present (*e.g.* the ratio of the sum of the powers of all harmonic components to the power of the fundamental frequency of the AC current *Ip*)*.*

Based on the outcome of the harmonic analysis (*e*.*g*. the assessment of secondary components and/or the calculation of the total harmonic distortion *THD*)*,* the control unit **130** according to embodiments of the present invention can detect malfunctioning conditions of the electric loads **127,** for example a compressor motor bad condition or a compressor inverter failure, and detect disturbances on the AC power source **115** caused by other electric appliances fed by the same AC power source **115.**

For example, according to an advantageous embodiment of the present invention, through the harmonic analysis, *e*.*g*. carried out by means of a FFT, the control unit **130** may detect spurious frequency contents on the spectrum of the AC current *Ip* (carrier or modulation). If spurious frequency contents are detected, the control unit **130** may diagnose a malfunctioning condition of the electric loads **127,** such as an inverter malfunction - *i.e.,* a partially damaged driver - or an incorrect motor condition.

According to an advantageous embodiment of the present invention, the harmonic analysis carried out on a signal having a harmonic content very similar to the one of the current *Ip,* made possible by having the low input resistance current sensor **180,** can be advantageously exploited for assessing, preferably in real time, whether there are private available AC power supplies, such as the renewable power supply **125** *(e.g.,* photovoltaic panel) of **Figure 1****,** which are providing additional electric power or not.

Making reference to **Figure 1****,** the renewable power supply **125** may preferably comprise a modulator unit **190** adapted to modulate the AC current generated by the renewable power supply **125** itself with an AC identification signal oscillating at a higher frequency (such as for example in the range 30 - 300 KHz) when the renewable power supply **125** is operating and is delivering additional electric power.

In this way, according to an advantageous embodiment of the present invention, if the results of the harmonic analysis carried out on the AC current *Ip* absorbed by the electric appliance **100** provides that the AC current *Ip* comprises a component oscillating at the frequency of a known identification signal, the control unit **130** may assess that the renewable power supply **125** corresponding to said specific identification signal is currently delivering electric power. Moreover, the control unit **130** may also advantageously comprise a demodulation unit configured for demodulating Power Line Communication (PLC) signals transmitted by the private available AC power supplies, such as the renewable power supply **125.**

According to an advantageous embodiment of the present invention, the possibility of knowing, preferably in real time, if renewable power supplies **125** are currently delivering electric power or not, can be advantageously exploited to program the operation of the electric appliance **100** according to an optimized schedule, for example to reduce costs. For example, if the electric appliance **100** is a washing machine, the execution of a washing cycle may be temporarily paused by the control unit **130** until a renewable power supply **125** is assessed to be actually delivering additional electric power.

Naturally, in order to satisfy local and specific requirements, a person skilled in the art may apply to the solution described above many logical and/or physical modifications and alterations. Moreover, it is expressly intended that specific elements and/or method steps described in connection with any disclosed embodiment of the invention may be incorporated in any other embodiment.

For example, even if in the description reference has been explicitly made to the use of a current sensor configured to exploit the Hall effect, the concepts of the present invention can be applied to other types of current sensors adapted to measure the (total) AC current absorbed by the electric appliance (i.e. the overall current consumption of the electric appliance), provided that the input resistance thereof is sufficiently low (*e.g.,* from 0,1 to 1 mΩ) to generate a corresponding signal to be provided to the control unit having a harmonic content sufficiently similar to the one of the current absorbed by the electric appliance.

## Claims

1. A domestic or commercial electric appliance (**100**) comprising:
- at least one electric load (**127**);
- an AC power supply input (**112**) connectable to an AC power source (**115**) for receiving electric power from said power source (**115**) and arranged to supply electric power to said at least one electric load (**127**), the AC power source comprising a private available AC power supply (125) connected to said AC
power supply unit (112), wherein the private available AC power supply is an AC power generator which is directly managed by a private user, comprises a modulator unit adapted to modulate AC current generated by the private AC power supply with an identification signal when the AC power generator is operating and delivering additional power and further comprises a domestic photovoltaic panel or a micro-wind turbine generator;
- a current sensor (**180**) for sensing an AC current absorbed by the electric appliance from the AC power source; and
- a processing unit (**130**) for carrying out an harmonic analysis on a sensed AC current sensed by the current sensor (**180**) and for driving the at least one electric load (**127**) based on an outcome of said harmonic analysis, wherein said processing unit (**130**) is configured to assess a presence, in a sensed AC current, of at least one secondary component oscillating at a frequency higher than a fundamental frequency of a main component of said sensed AC current, and to detect if said at least one secondary component corresponds to an identification signal generated by the private available AC power supply (**125**), wherein the processing unit (**130**) is further configured to drive said at least one electric load (**127**) based on said identification signal.

2. A domestic or commercial electric appliance (**100**) according to claim 1, wherein said current sensor is a Hall current sensor.

3. The domestic or commercial electric appliance (**100**) of claim 1 or 2, wherein the processing unit (**130**) is configured to calculate the total harmonic distortion of the sensed AC current, and to assess at least one among:
- malfunctioning conditions of the at least one electric load (**127**), and
- disturbances on the AC power source caused by other electric appliances,
based on the calculated total harmonic distortion.

4. The domestic or commercial electric appliance (**100**) of any one among the preceding claims, wherein the processing unit (**130**) is configured to carry out the harmonic analysis on the sensed AC current by applying a Fast Fourier Transform to the sensed AC current.

5. The domestic or commercial electric appliance (**100**) of any one among the preceding claims, wherein the processing unit (**130**) is configured to assess anomalous operation conditions or malfunction conditions of the at least one electric load (**127**) based on the sensed AC current.

6. The domestic or commercial electric appliance (**100**) of any one among the preceding claims, wherein the processing unit (**130**) is further configured to assess the electric power consumption of the at least one electric load (**127**) based on the sensed AC current.

7. The domestic or commercial electric appliance (**100**) of any one among the preceding claims, wherein the processing unit (**130**) is further configured to assess an overload condition of the AC power source (**115**) based on sensed AC current.

8. The domestic or commercial electric appliance (**100**) of any one among the preceding claims, wherein said electric appliance is a refrigerator, and wherein said at least one electric load (**127**) comprise at least one among:
- an inverter unit;
- a compressor unit;
- a defrost heating resistor.

9. The domestic or commercial electric appliance (**100**) of any one among the preceding claims, wherein said electric appliance is a laundry washing machine, and wherein said at least one electric load (**127**) comprises at least one among:
- a drain pump;
- a recirculation pump;
- an drum motor circuit;
- a heating resistor.

10. The domestic or commercial electric appliance (**100**) of any one among the preceding claims, wherein said electric appliance is a laundry dryer machine, and wherein said at least one electric load (**127**) comprises at least one among:
- an drum motor circuit;
- a heating resistor;
- a compressor unit;
- a fan.

11. The domestic or commercial electric appliance (**100**) of any one among the preceding claims, wherein said electric appliance is an oven, and wherein said at least one electric load (**127**) comprises at least one among:
- a heating resistor;
- a microwave generator unit;
- a fan.

12. An electric system (**150**) comprising a domestic or commercial electric appliance (**100**) according to any one among the preceding claims and an AC power source (**115**) connected to the AC power supply input (**112**) of said domestic or commercial electric appliance (**100**), wherein said AC power source (**115**) is adapted to provide to said AC power supply input (**112**) an electric power having a fundamental frequency being an utility frequency of a public available AC power supply (**120**)

13. The electric system (**150**) of claim 12, wherein:
- said AC power source (**115**) includes at least one private available AC power supply (**125**), wherein the private available AC power supply is an AC power generator which is directly managed by a private user and each private available AC power supply being configured to generate additional electric power and a corresponding identification signal when activated.

## Patentansprüche

1. Haushalts- oder gewerbliches Elektrogerät (100), das Folgendes umfasst:
- zumindest eine elektrische Last (127);
- einen Wechselstromleistungsversorgungseingang (112), verbindbar mit einer Wechselstromleistungsquelle (115), zum Empfangen von elektrischer Leistung von der Leistungsquelle (115) und angeordnet zum Zuführen von elektrischer Leistung zu der zumindest einen elektrischen Last (127), wobei die Wechselstromleistungsquelle eine private verfügbare Wechselstromleistungsversorgung (125) umfasst, die mit der Wechselstromleistungsversorgungseinheit (112) verbunden ist, wobei die private verfügbare Wechselstromleistungsversorgung ein Wechselstromleistungsgenerator ist, der durch einen privaten Benutzer direkt verwaltet wird, eine Modulatoreinheit umfasst, die angepasst ist zum Modulieren von durch die private Wechselstromleistungsversorgung erzeugtem Wechselstrom mit einem Identifizierungssignal, wenn der Wechselstromleistungsgenerator arbeitet und zusätzliche Leistung liefert, und ferner ein Haushaltssolarpaneel oder einen Mikro-Windturbinengenerator umfasst;
- einen Stromsensor (180) zum Erfassen eines durch das Elektrogerät absorbierten Wechselstroms von der Wechselstromleistungsquelle; und
- eine Verarbeitungseinheit (130) zum Ausführen einer Frequenzanalyse auf einem erfassten Wechselstrom, erfasst durch den Stromsensor (180), und zum Ansteuern der zumindest einen elektrischen Last (127) basierend auf einem Ergebnis der Frequenzanalyse, wobei die Verarbeitungseinheit (130) ausgelegt ist zum Beurteilen einer Anwesenheit, in einem erfassten Wechselstrom, von zumindest einer sekundären Komponente, die bei einer Frequenz oszilliert, die höher als eine Grundfrequenz einer Hauptkomponente des erfassten Wechselstroms ist, und zum Detektieren, ob die zumindest eine sekundäre Komponente einem durch die private verfügbare Wechselstromleistungsversorgung (125) erzeugten Identifizierungssignal entspricht, wobei die Verarbeitungseinheit (130) ferner ausgelegt ist zum Ansteuern der zumindest einen elektrischen Last (127) basierend auf dem Identifizierungssignal.

2. Haushalts- oder gewerbliches Elektrogerät (100) nach Anspruch 1, wobei der Stromsensor ein Hall-Stromsensor ist.

3. Haushalts- oder gewerbliches Elektrogerät (100) nach Anspruch 1 oder 2, wobei die Verarbeitungseinheit (130) ausgelegt ist zum Berechnen des Gesamtoberschwingungsverhältnisses des erfassten Wechselstroms und zum Beurteilen von zumindest einem aus:
- Fehlfunktionsbedingungen der zumindest einen elektrischen Last (127), und
- Störungen an der Wechselstromleistungsquelle, verursacht durch andere Elektrogeräte, basierend auf dem berechneten Gesamtoberschwingungsverhältnis.

4. Haushalts- oder gewerbliches Elektrogerät (100) nach einem der vorhergehenden Ansprüche, wobei die Verarbeitungseinheit (130) ausgelegt ist zum Ausführen der Frequenzanalyse auf dem erfassten Wechselstrom durch Anwenden einer schnellen Fourier-Transformation auf den erfassten Wechselstrom.

5. Haushalts- oder gewerbliches Elektrogerät (100) nach einem der vorhergehenden Ansprüche, wobei die Verarbeitungseinheit (130) ausgelegt ist zum Beurteilen anomaler Betriebsbedingungen oder von Fehlfunktionsbedingungen der zumindest einen elektrischen Last (127) basierend auf dem erfassten Wechselstrom.

6. Haushalts- oder gewerbliches Elektrogerät (100) nach einem der vorhergehenden Ansprüche, wobei die Verarbeitungseinheit (130) ferner ausgelegt ist zum Beurteilen des elektrischen Leistungsverbrauchs der zumindest einen elektrischen Last (127) basierend auf dem erfassten Wechselstrom.

7. Haushalts- oder gewerbliches Elektrogerät (100) nach einem der vorhergehenden Ansprüche, wobei die Verarbeitungseinheit (130) ferner ausgelegt ist zum Beurteilen einer Überlastbedingung der Wechselstromleistungsquelle (115) basierend auf dem erfassten Wechselstrom.

8. Haushalts- oder gewerbliches Elektrogerät (100) nach einem der vorhergehenden Ansprüche, wobei das Elektrogerät ein Kühlschrank ist und wobei die zumindest eine elektrische Last (127) eines aus Folgendem umfasst:
- eine Umrichtereinheit;
- eine Verdichtereinheit;
- einen Abtauheizwiderstand.

9. Haushalts- oder gewerbliches Elektrogerät (100) nach einem der vorhergehenden Ansprüche, wobei das Elektrogerät eine Wäschewaschmaschine ist und wobei die zumindest eine elektrische Last (127) eines aus Folgendem umfasst:
- eine Ablasspumpe;
- eine Umwälzpumpe;
- eine Trommelmotorschaltung;
- einen Heizwiderstand.

10. Haushalts- oder gewerbliches Elektrogerät (100) nach einem der vorhergehenden Ansprüche, wobei das Elektrogerät eine Wäschetrocknermaschine ist und wobei die zumindest eine elektrische Last (127) eines aus Folgendem umfasst:
- eine Trommelmotorschaltung;
- einen Heizwiderstand;
- eine Verdichtereinheit;
- ein Gebläse.

11. Haushalts- oder gewerbliches Elektrogerät (100) nach einem der vorhergehenden Ansprüche, wobei das Elektrogerät ein Ofen ist und wobei die zumindest eine elektrische Last (127) eines aus Folgendem umfasst:
- einen Heizwiderstand;
- eine Mikrowellengeneratoreinheit;
- ein Gebläse.

12. Elektrisches System (150), umfassend ein Haushalts-oder gewerbliches Elektrogerät (100) nach einem der vorhergehenden Ansprüche und eine Wechselstromleistungsquelle (115), verbunden mit einem Wechselstromleistungsversorgungseingang (112) des Haushalts- oder gewerblichen Elektrogeräts (100), wobei die Wechselstromleistungsquelle (115) angepasst ist zum Bereitstellen, für den Wechselstromleistungsversorgungseingang (112), einer elektrischen Leistung mit einer Grundfrequenz, die eine Arbeitsfrequenz einer öffentlichen verfügbaren Wechselstromleistungsversorgung (120) ist.

13. Elektrisches System (150) nach Anspruch 12, wobei:
- die Wechselstromleistungsquelle (115) zumindest eine private verfügbare Wechselstromleistungsversorgung (125), umfasst, wobei die private verfügbare Wechselstromleistungsversorgung ein Wechselstromleistungsgenerator ist, der durch einen privaten Benutzer direkt verwaltet wird, und wobei jede private verfügbare Wechselstromleistungsversorgung ausgelegt ist zum Erzeugen zusätzlicher elektrischer Leistung und eines entsprechenden Identifizierungssignals, wenn aktiviert.

## Revendications

1. Appareil électrique domestique ou commercial (100) comprenant :
- au moins une charge électrique (127) ;
- une entrée d'alimentation en c.a. (112) connectable à une source d'alimentation en c.a. (115) pour recevoir une alimentation électrique venant de ladite source d'alimentation (115) et agencée de façon à alimenter un courant électrique à ladite au moins une charge électrique (127), la source d'alimentation en c.a. comprenant une alimentation en c.a. disponible privée (125) connectée à ladite unité d'alimentation en c.a. (112), l'alimentation en c.a. disponible privée étant un générateur de courant alternatif qui est géré directement par un utilisateur privé, comprenant une unité modulateur adaptée de façon à moduler le courant alternatif généré par l'alimentation en c.a. privée avec un signal d'identification lorsque le générateur de courant alternatif fonctionne et fournissant une énergie supplémentaire et comprenant en outre un panneau photovoltaïque domestique ou un générateur de micro-éolienne ;
- un capteur de courant (180) pour détecter un courant alternatif absorbé par l'appareil électrique venant de la source d'alimentation en c.a. ; et
- une unité de traitement (130) pour exécuter une analyse harmonique sur un courant alternatif détecté par le capteur de courant (180) et pour commander l'au moins une charge électrique (127) en se basant sur un résultat de ladite analyse harmonique, ladite unité de traitement (130) étant configurée de façon à évaluer une présence, dans un courant alternatif détecté, d'au moins une composante secondaire oscillant à une fréquence plus élevée qu'une fréquence fondamentale d'une composante principale dudit courant alternatif détecté, et de façon à détecter si ladite au moins une composante secondaire correspond à un signal d'identification généré par l'alimentation en c.a. disponible privée (125), l'unité de traitement (130) étant configurée en outre de façon à commander ladite au moins une charge électrique (127) en se basant sur ledit signal d'identification.

2. Appareil électrique domestique ou commercial (100) selon la revendication 1, dans lequel ledit capteur de courant est un capteur de courant Hall.

3. Appareil électrique domestique ou commercial (100) selon la revendication 1 ou 2, dans lequel l'unité de traitement (130) est configurée de façon à calculer la distorsion harmonique totale du courant alternatif détecté, et à évaluer au moins au moins une des conditions suivantes :
- des conditions de mauvais fonctionnement de l'au moins une charge électrique (127), et
- des perturbations sur la source d'alimentation en c.a. causées par d'autres appareils électriques, en se basant sur la distorsion harmonique totale calculée.

4. Appareil électrique domestique ou commercial (100) selon l'une quelconque des revendications précédentes, dans lequel l'unité de traitement (130) est configurée de façon à exécuter l'analyse harmonique sur le courant alternatif détecté en appliquant une transformation de Fourier rapide sur le courant alternatif détecté.

5. Appareil électrique domestique ou commercial (100) selon l'une quelconque des revendications précédentes, dans lequel l'unité de traitement (130) est configurée de façon à évaluer des conditions de fonctionnement anormales ou des conditions de mauvais fonctionnement de l'au moins une charge électrique (127) en se basant sur le courant alternatif détecté.

6. Appareil électrique domestique ou commercial (100) selon l'une quelconque des revendications précédentes, dans lequel l'unité de traitement (130) est configurée en outre de façon à évaluer la consommation d'énergie électrique de l'au moins une charge électrique (127) en se basant sur le courant alternatif détecté.

7. Appareil électrique domestique ou commercial (100) selon l'une quelconque des revendications précédentes, dans lequel l'unité de traitement (130) est configurée de façon à évaluer une condition de surcharge de la source d'alimentation en c.a. (115) en se basant sur le courant alternatif détecté.

8. Appareil électrique domestique ou commercial (100) selon l'une quelconque des revendications précédentes, dans lequel ledit appareil électrique est un réfrigérateur, et dans lequel ladite au moins une charge électrique (127) comprend au moins un des éléments suivants :
- une unité onduleur ;
- une unité compresseur ;
- une résistance de chauffage de dégivrage.

9. Appareil électrique domestique ou commercial (100) selon l'une quelconque des revendications précédentes, dans lequel ledit appareil électrique est un lave-linge, et dans lequel ladite au moins une charge électrique (127) comprend au moins un des éléments suivants :
- une pompe de vidange ;
- une pompe de recirculation ;
- un circuit de moteur de tambour ;
- une résistance de chauffage.

10. Appareil électrique domestique ou commercial (100) selon l'une quelconque des revendications précédentes, dans lequel ledit appareil électrique est un sèche-linge, et dans lequel ladite au moins une charge électrique (127) comprend au moins un des éléments suivants :
- un circuit de moteur de tambour ;
- une résistance de chauffage.
- une unité compresseur ;
- un ventilateur.

11. Appareil électrique domestique ou commercial (100) selon l'une quelconque des revendications précédentes, dans lequel ledit appareil électrique est un four, et dans lequel ladite au moins une charge électrique (127) comprend au moins un des éléments suivants :
- une résistance de chauffage.
- un générateur de micro-ondes ;
- un ventilateur.

12. Système électrique (150) comprenant un appareil électrique domestique ou commercial (100) selon l'une quelconque des revendications précédentes et une source d'alimentation en c.a. (115) connectée à l'entrée d'alimentation en c.a. (112) dudit appareil électrique domestique ou commercial (100), ladite source d'alimentation en c.a. (115) étant adaptée de façon à fournir à ladite entrée d'alimentation en c.a. (112) une énergie électrique ayant une fréquence fondamentale étant une fréquence d'utilité d'une alimentation en c.a. disponible publique (120).

13. Système électrique (150) selon la revendication 12, dans lequel
- ladite source d'alimentation en c.a. (115) comprend au moins une alimentation en c.a. disponible privée (125), cette alimentation en c.a. disponible privée étant un générateur de courant alternatif qui est géré directement par un utilisateur privé et chaque alimentation en c.a. disponible privée étant configurée de façon à générer une énergie électrique supplémentaire et un signal d'identification correspondant lorsqu'elle est activée.
